# EUROPEAN PATENT APPLICATION

(11) **EP 4 622 405 A2**
(43) Date of publication of application: **24.09.2025**
(21) Application number: 25165071.9
(22) Date of filing: 20.03.2025
(51) Int. Cl.: H05K 3/22, H05K 3/00, H05K 3/12, H05K 3/26

(54) **SINGLE LASER REPAIR DEVICE AND OPERATING METHOD THEREOF**

(30) Priority: 22.03.2024 TW 113110832
(71) Applicant: Manz Taiwan Ltd., Taoyuan City 320 (TW)
(72) Inventor: YEN, Chun-Ying, 320 Taoyuan City (TW)
(74) Representative: Lang, Christian

(57) **Abstract**

A single laser repair device and operating method thereof is used to carry out repairs on a defective circuit of a circuit board, wherein the defective circuit has two conducting portions and a defective portion therebetween. The operating method comprises: using a laser light source of a single laser dual optical circuit repair member of a single laser repair module to emit an initial laser beam toward an energy distribution unit, thereby producing a first laser beam and a second laser beam different from the first laser beam; using a switching unit to mask the second laser beam, thereby enabling transmitting the first laser beam toward the circuit board after passing through the switching unit, to transform the defective portion into a sintered portion; and using the switching unit to mask the first laser beam, thereby enabling transmitting the second laser beam toward the circuit board after passing through the switching unit, to carry out deflashing of the sintered portion, causing sintered sides of the sintered portion to be flush with two conducting sides of the two conducting portions.

## Description

### BACKGROUND OF THE INVENTION

### (a) Field of the Invention

The content of the present disclosure relates to a single laser repair device, and an operating method for the single laser repair device, and more particularly to a single laser repair device (100) and operating method thereof for sintering and deflashing a circuit (210) of a circuit board (200) with open circuit defects and short circuit defects.

### (b) Description of the Prior Art

In general, a laser repair device can be used for repairing circuits of circuit boards with short circuit defects and open circuit defects. For example, a laser repair device uses a laser head to emit a laser beam toward a defect of a circuit. However, when the laser repair device is proceeding with repairing the defective circuit, because the energy of the laser beam is too unduly focused or the angle of divergence of the laser beam is too large, the repaired circuit is prone to contacting circuits adjacent thereto, forming short circuits or causing other defects.

### SUMMARY OF THE INVENTION

The technical aspect of this disclosure lies in a single laser repair device that enables preventing a repaired circuit from easily contacting other circuits adjacent thereto, thereby avoiding short-circuiting.

According to an embodiment mode of the present disclosure, a single laser repair device is provided that is used to carry out repairs on a defective circuit of a circuit board, wherein the defective circuit is provided with two conducting portions and has a defective portion located therebetween. The single laser repair device comprises a single laser repair module, which comprises a single laser dual optical circuit repair member. More specifically, the single laser dual optical circuit repair member is configured in the single laser repair module, and the single laser dual optical circuit repair member comprises a laser light source, an energy distribution unit, and a switching unit. The laser light source is used to emit an initial laser beam, and the energy distribution unit is configured on one side of the laser light source. The initial laser beam passes through the energy distribution unit, thereby producing a first laser beam and a second laser beam different from the first laser beam, and the energy of the first laser beam is different from the energy of the second laser beam. The switching unit is configured on one side of the energy distribution unit, and is used to mask the second laser beam, thereby enabling transmitting the first laser beam toward the circuit board after passing through the switching unit, to transform the defective portion of the circuit into a sintered portion. After transforming the defective portion of the circuit into the sintered portion, the switching unit is used to mask the first laser beam, thereby enabling transmitting the second laser beam toward the circuit board after passing through the switching unit, to carry out deflashing of the sintered portion, causing sintered sides of the sintered portion to be flush with two conducting sides of the two conducting portions.

According to an embodiment mode of the present disclosure, the above-described single laser dual optical circuit repair member further comprises a first laser spot adjustment unit and a second laser spot adjustment unit, wherein the first laser spot adjustment unit is positioned between the energy distribution unit and the switching unit, and is used to receive the first laser beam after passing through the energy distribution unit. The second laser spot adjustment unit is positioned to one side of the first laser spot adjustment unit, and is used to receive the second laser beam after passing through the energy distribution unit. The angle of divergence of the first laser beam passing through the first laser spot adjustment unit is different from the another angle of divergence of the second laser beam passing through the second laser spot adjustment unit.

According to an embodiment mode of the present disclosure, the energy of the first laser beam after passing through the energy distribution unit is greater than the energy of the second laser beam after passing through the energy distribution unit and/or the angle of divergence of the first laser beam after passing through the laser spot adjustment unit is greater than the another angle of divergence of the second laser beam after passing through the laser spot adjustment unit.

According to an embodiment mode of the present disclosure, the aforementioned two conducting portions are two metal conducting wires or two polysilicon fuses, and the defects of the circuit are short circuit defects. The first laser beam is used to sinter the defective portion, causing a portion of the defective portion to diffuse outward and exposing a portion of the substrate of the circuit board, thereby transforming the defective portion into a sintered portion. A width of each of the two conducting portions is smaller than a width of the portion of the substrate exposed by the sintered portion.

According to an embodiment mode of the present disclosure, the aforementioned two conducting portions are two metal conducting wires or two polysilicon fuses, and the defect of the circuit is an open circuit defect. The first laser beam is used to sinter two corresponding sides of the two conducting portions to diffusely cover the defective portion, thereby transforming the defective portion into a sintered portion and affording electrical conduction with the two conducting portions.

According to an embodiment mode of the present disclosure, the aforementioned two conducting portions are two metal conducting wires or two polysilicon fuses, and the defect of the circuit is an open circuit defect. The single laser repair module is provided with an inkjet head, which is used to spray a conductive resin on the defective portion of the circuit, causing the conductive resin to partially cover the two conducting portions. The first laser beam is used to sinter the conductive resin located on the circuit, thereby transforming the defective portion into the sintered portion.

According to an embodiment mode of the present disclosure, the above-described single laser repair device further comprises a first displacement module, a second displacement module, a third displacement module, and measuring modules, wherein the first displacement module is connected to the single laser repair module, and is used to displace the single laser repair module in the first direction. The second displacement module is connected to the first displacement module, and is used to displace the first displacement module in a second direction. The third displacement module is provided with a loading platform, which is used to load-support a circuit board, and the third displacement module is used to displace the loading platform in a third direction. Each of the first direction, the second direction, and the third direction is perpendicular to the other two directions. The measuring modules are correspondingly mounted on two sides of the third displacement module, whereby when the third displacement module drives and moves the loading platform through the measuring modules, the measuring modules are used to measure a thickness of the circuit in the circuit board.

According to an embodiment mode of the present disclosure, the above-described single laser repair module is provided with a detector lens. The detector lens is orientated toward the circuit board, and is used to detect the current position of the circuit board and produce a drive signal according to the current position, wherein the drive signal is used to drive movement of the first displacement module, the second displacement module, and the third displacement module, thereby enabling positioning the single laser repair module and the circuit board at a specific position.

Another technical aspect of the present disclosure lies in the operating method of the single laser repair device, wherein the single laser repair device is used to carry out repairs on a defective circuit in a circuit board, which enables preventing a repaired circuit from easily contacting other circuits adjacent thereto, thereby avoiding short-circuiting.

According to an embodiment mode of the present disclosure, the operating method for the single laser repair device provided in the present disclosure is used to carry out repairs on a defective circuit in a circuit board, wherein the defective circuit is provided with the two conducting portions and has the defective portion located therebetween. The operating method comprises: using the laser light source of the single laser dual optical circuit repair member of the single laser repair module to emit the initial laser beam toward the energy distribution unit, thereby producing the first laser beam and the second laser beam different from the first laser beam, wherein the energy of the first laser beam is different from the energy of the second laser beam; using the switching unit to mask the second laser beam, thereby enabling transmitting the first laser beam toward the circuit board after passing through the switching unit, to transform the defective portion of the defective circuit into the sintered portion; and using the switching unit to mask the first laser beam, thereby enabling transmitting the second laser beam toward the circuit board after passing through the switching unit, to carry out deflashing of the sintered portion, causing the sintered sides of the sintered portion to be flush with the two conducting sides of the two conducting portions.

According to an embodiment mode of the present disclosure, the above-described operating method further comprises: using the first laser spot adjustment unit to receive the first laser beam after passing through the energy distribution unit, and using the second laser spot adjustment unit to receive the second laser beam after passing through the energy distribution unit, wherein the angle of divergence of the first laser beam after passing through the first laser spot adjustment unit is different from the another angle of divergence of the second laser beam after passing through the second laser spot adjustment unit.

According to an embodiment mode of the present disclosure, transforming the aforementioned defective portion into the sintered portion also comprises: using the first laser beam to sinter the two corresponding sides of the two conducting portions to diffusely cover the defective portion, transforming the defective portion into the sintered portion and affording electrical conduction with the two conducting portions.

According to an embodiment mode of the present disclosure, transforming the aforementioned defective portion into the sintered portion also comprises: removing a portion of the circuit, causing the circuit to have a defective portion, wherein the defect of the circuit is an open circuit defect, and the two conducting portions are two metal conducting wires or two polysilicon fuses; using the inkjet head of the single laser repair module to spray a conductive resin on the defective portion of the circuit, wherein the conductive resin partially covers the two conducting portions; and using the first laser beam to sinter the conductive resin located on the circuit, transforming the defective portion into the sintered portion.

According to an embodiment mode of the present disclosure, transforming the aforementioned defective portion into the sintered portion also comprises: using the first laser beam to sinter the defective portion, causing a portion of the defective portion to diffuse outward, exposing a portion of the substrate of the circuit board, thereby transforming the defective portion into the sintered portion, wherein the defect of the circuit is a short circuit defect, and a width of each of the two conducting portions is smaller than a width of the portion of the substrate exposed by the sintered portion.

According to an embodiment mode of the present disclosure, the above-described operating method also comprises: driving and displacing the first displacement module, the second displacement module, and the third displacement module along the first direction, the second direction, and the third direction, respectively, thereby displacing the single laser repair module connected to the first displacement module and the circuit board on the loading platform of the third displacement module, wherein each of the first direction, the second direction, and the third direction is perpendicular to the other two directions; using the detector lens of the single laser repair module to detect the current position of the circuit board and produce a drive signal according to the current position, wherein the drive signal is used to activate displacement of the first displacement module, the second displacement module, and the third displacement module, thereby enabling positioning the single laser repair module and the circuit board at a specific position.

According to an embodiment mode of the present disclosure, the above-described operating method also comprises: displacing the loading platform on the third displacement module, enabling the loading platform to pass through the measuring modules mounted on two sides of the third displacement module, to measure a thickness of the circuit in the circuit board.

According to the above-described embodiment modes of the present disclosure, the single laser repair device is used to carry out repairs on defective circuits with short circuit defects in a circuit board. The single laser dual optical circuit repair member enables emitting the first laser beam and the second laser beam with different energies and/or different angle of divergence toward the circuit board. In addition, the first laser beam emitted by the single laser dual optical circuit repair member transforms the defective portion of the circuit into the sintered portion between the two conducting portions; and the second laser beam emitted by the single laser dual optical circuit repair member carries out deflashing of the sintered portion, causing the sintered sides of the sintered portion to be flush with the two conducting sides of the two conducting portions. The configuration of the first laser beam and second laser beam emitted by the single laser dual optical circuit repair member of the single laser repair device enables the side surfaces of the repaired circuit to avoid contact with other circuits, thereby preventing short circuiting of the repaired circuit, or other defects from occurring.

To enable a further understanding of said objectives, structures, characteristics, and effects, as well as the technology and methods used in the present invention and effects achieved, a brief description of the drawings is provided below followed by a detailed description of the preferred embodiments.

### BRIEF DESCRIPTION OF THE DRAWINGS

When read in conjunction with the accompanying drawings, the embodiment modes of the disclosure are best understood from the following detailed description. It should be emphasized, based on standard industrial practices, the characteristics illustrated in the drawings are not drawn to scale and are used for illustrative purposes only. To clarify, in reality, the sizes of the various features can be arbitrarily increased or decreased.
Figure 1 is a three-dimensional view of an embodiment mode of a single laser repair device according to the present disclosure.
Figure 2 is a front view of a single laser repair module of Figure 1.
Figure 3 is a schematic view of an embodiment mode of a single laser dual optical circuit repair member emitting a first laser beam according to the present disclosure.
Figure 4 is a schematic view of an embodiment mode of the single laser dual optical circuit repair member emitting a second laser beam according to the present disclosure.
Figure 5 is a flow chart of the operating method of an embodiment mode of the single laser repair device according to the present disclosure.
Figures 6 to 8 are cross-sectional views of a circuit of a circuit board with an open circuit defect in different states while undergoing repair according to an embodiment mode of the present disclosure.
Figures 9 and 10 are top views of the circuit of the circuit board with the open circuit defect in different states while undergoing repair according to the embodiment mode of the present disclosure.
Figures 11 and 12 are cross-sectional views of the circuit of the circuit board with the open circuit defect in different states while undergoing repair according to an embodiment mode of the present disclosure.
Figures 13 and 14 are top views of the circuit of the circuit board with the open circuit defect in different states while undergoing repair according to the embodiment of the present disclosure.
Figures 15 and 16 are cross-sectional views of the circuit of the circuit board with the short circuit defect in different states while undergoing repair according to an embodiment of the present disclosure.
Figures 17 to 19 are top views of the circuit of the circuit board with the short circuit defect in different states while undergoing repair according to the embodiment of the present disclosure.

### DETAILED DESCRIPTION OF THE PREFERRED EMBODIMENTS

The following content provides a detailed description of a number of different embodiment modes or examples for implementing the different characteristics thereof. Specific examples of component members and configurations are described below to simplify the specification. It is understood that such examples are only illustrative, and the present invention is not limited by such. In addition, numbers and/or letters of component members may be repeated in each of the examples described in the present disclosure. This repetition is for the purpose of simplicity and clarity, and itself does not specify a relationship between each of the embodiment modes and/or configurations described.

For example, spatial relation terminology such as "below ......", "under......", "lower portion", "on top of ......", "upper portion", etc., are used herein for the purpose of ease of description, to describe a component member shown in the accompanying drawings or the relationship between a characteristic and another component member or characteristic. Apart from specifying orientations shown in the accompanying drawings, the spatial relation terminology is also intended to include other orientations than those shown in the accompanying drawings or different orientations of the device during operation. In other words, the device can be oriented in other ways (rotated 90 degrees or other orientations), and the spatial relative descriptors used in this specification can be interpreted accordingly.

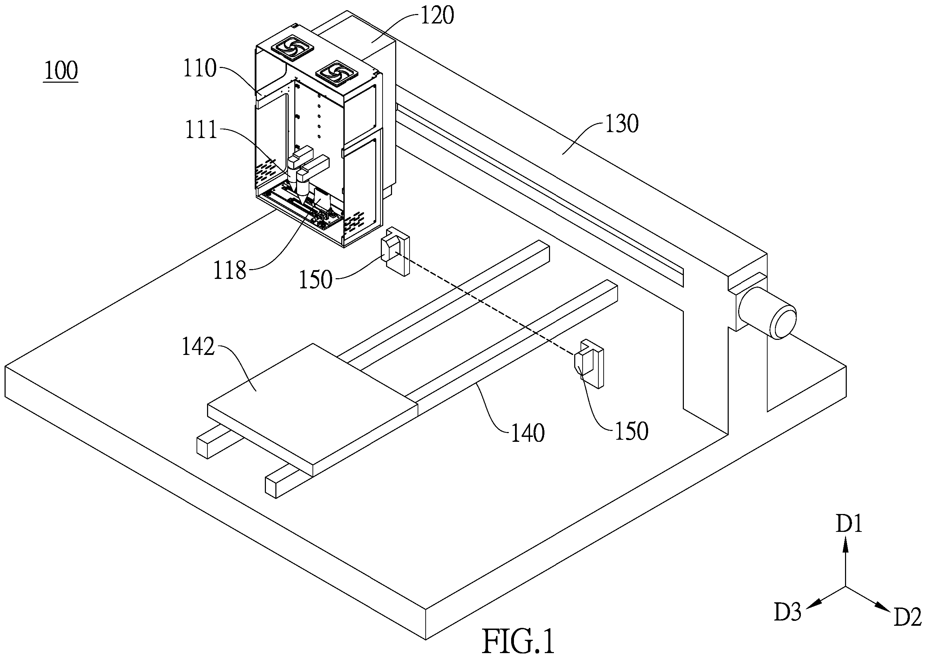

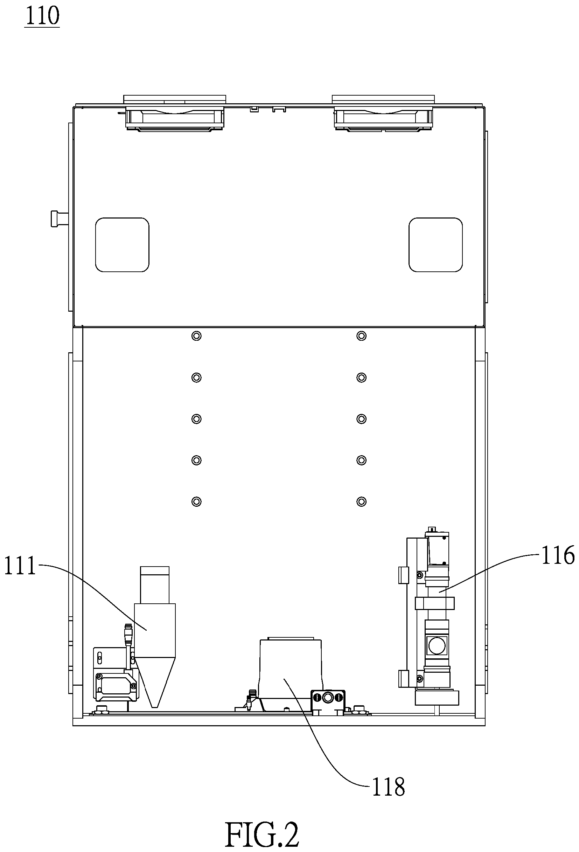

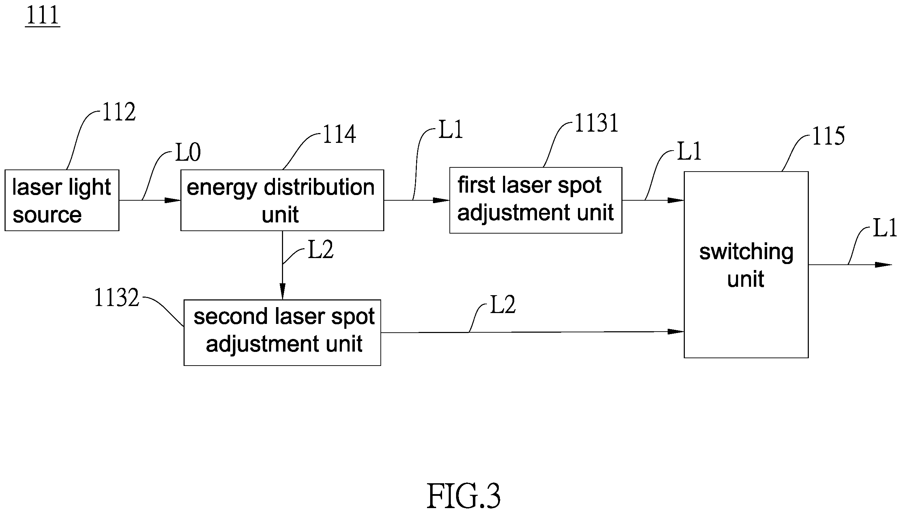

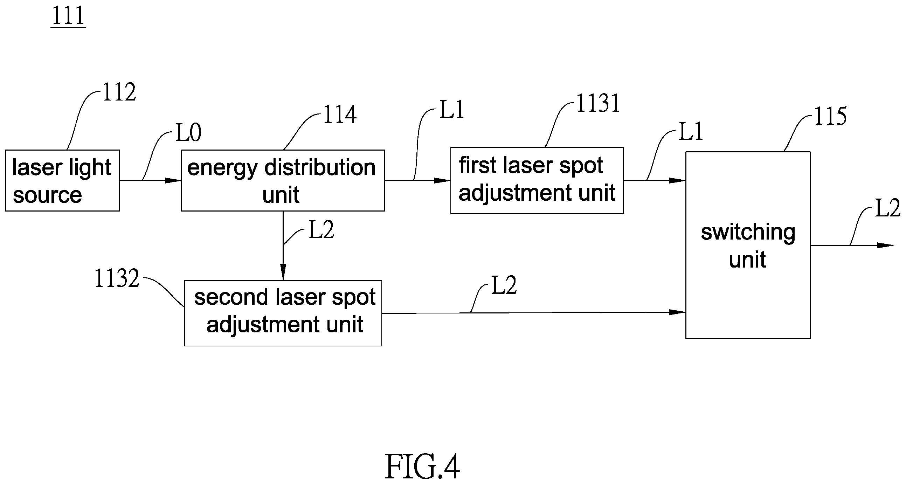

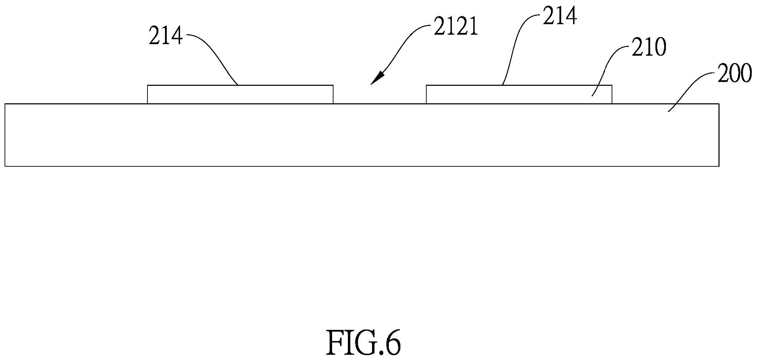

Referring to Figures 1 to 4, wherein Figure 1 is a three-dimensional view of an embodiment mode of a single laser repair device 100 according to the present disclosure, Figure 2 is a front view of a single laser repair module 110 of Figure 1, Figure 3 is a schematic view of an embodiment mode of a single laser dual optical circuit repair member 111 emitting a first laser beam L1 according to the present disclosure, and Figure 4 is a schematic view of an embodiment mode of the single laser dual optical circuit repair member 111 emitting a second laser beam L2 according to the present disclosure. Accordingly, the single laser repair device 100 is used to carry out repairs on a defective circuit 210 (will be described in Figure 6) of a circuit board 200 (a detailed description is given in Figure 6), wherein the single laser repair device 100 comprises the single laser repair module 110, which comprises the single laser dual optical circuit repair member 111.

In some of the embodiment modes, the single laser dual optical circuit repair member 111 comprises a laser light source 112, an energy distribution unit 114, and a switching unit 115, wherein the laser light source 112 is used to emit an initial laser beam L0, and the energy distribution unit 114 is configured on one side of the laser light source 112. The initial laser beam L0 passes through the energy distribution unit 114, thereby producing a first laser beam L1 and a second laser beam L2 different from the first laser beam L1, wherein the energy of the first laser beam L1 is different from the energy of the second laser beam L2. For example, the energy of the first laser beam L1 is greater than the energy of the second laser beam L2.

In some of the embodiment modes, the single laser dual optical circuit repair member 111 further comprises a first laser spot adjustment unit 1131 and a second laser spot adjustment unit 1132, wherein the first laser spot adjustment unit 1131 is positioned between the energy distribution unit 114 and the switching unit 115, and is used to receive the first laser beam L1 after passing through the energy distribution unit 114. The second laser spot adjustment unit 1132 is positioned to one side of the first laser spot adjustment unit 1131, and is used to receive the second laser beam L2 after passing through the energy distribution unit 114. The angle of divergence of the first laser beam L1 after passing through the first laser spot adjustment unit 1131 is different from the another angle of divergence of the second laser beam L2 after passing through the second laser spot adjustment unit 1132. For example, the angle of divergence of the first laser beam L1 is greater than the another angle of divergence of the second laser beam L2.

In some of the embodiment modes, the switching unit 115 is configured on one side of the energy distribution unit 114, and is used to mask the second laser beam L2, and also transmits the first laser beam L1 passing through the switching unit 115 toward the circuit board 200, or masks the first laser beam L1 and transmits the second laser beam L2 passing through the switching unit 115 toward the circuit board 200.

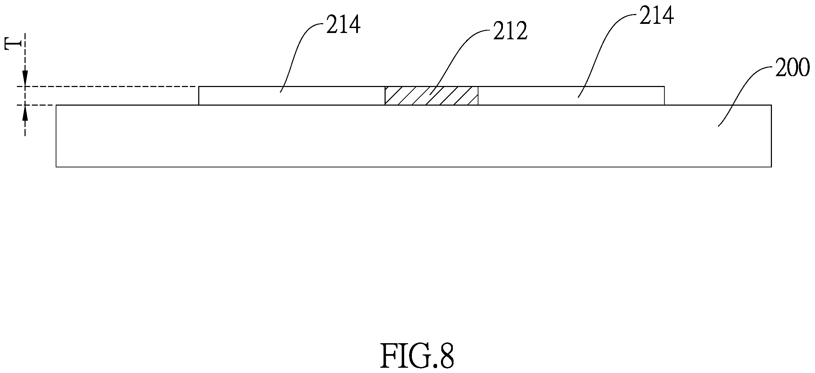

In some of the embodiment modes, the single laser repair device 100 further comprises a first displacement module 120, a second displacement module 130, a third displacement module 140, and measuring modules 150, wherein the first displacement module 120 is connected to the single laser repair module 110, and is used to displace the single laser repair module 110 in a first direction D1; the second displacement module 130 is connected to the first displacement module 120, and is used to displace the first displacement module 120 in a second direction D2; the third displacement module 140 is provided with a loading platform 142, which is used to load-support the circuit board 200. and the third displacement module 140 is used to displace the loading platform 142 in a third direction D3. Each of the first direction D1, the second direction D2, and the third direction D3 is perpendicular to the other two directions. The measuring modules 150 are correspondingly mounted on two sides of the third displacement module 140. When the third displacement module 140 drives and moves the loading platform 142 through the measuring modules 150, the measuring modules 150 are used to measure a thickness T (will be described in Figure 8) of the circuit 210 (will be described in Figure 6) in the circuit board 200(will be described in Figure 8).

Furthermore, the single laser repair module 110 is provided with a detector lens 116 and an inkjet head 118, wherein the detector lens 116 is orientated toward the circuit board 200 (will be described in Figure 6), and is used to detect the current position of the circuit board 200, to produce a drive signal according to the current position. The drive signal is used to drive movement of the first displacement module 120, the second displacement module 130, and the third displacement module 140, thereby enabling positioning the single laser repair module 110 and the circuit board 200 at a specific position.

It is hereby clarified that in the following description of the operating method of the single laser repair device, the connection relationship between the component members, the materials, and functions already described will not be repeated.

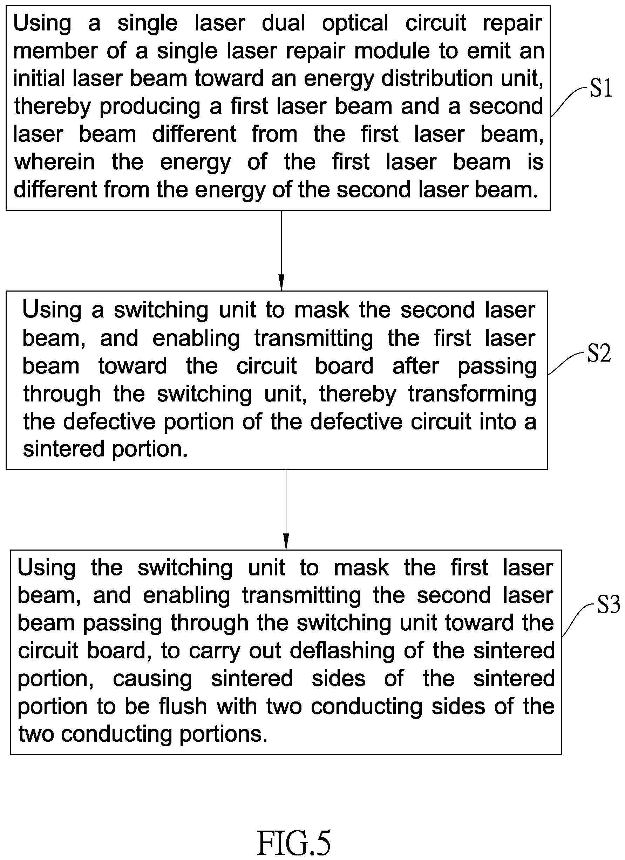

Referring to Figure 5, which shows a flow chart of the operating method of an embodiment mode of the single laser repair device according to the present disclosure, wherein the operating method of the single laser repair device comprises the following steps, first, in step a), a laser light source of a single laser dual optical circuit repair member of a single laser repair module emits an initial laser beam toward an energy distribution unit, thereby producing a first laser beam and a second laser beam different from the first laser beam, wherein the energy of the first laser beam is different from the energy of the second laser beam S1.

Please note, in other embodiment modes, other optical elements can be used to produce the first laser beam and the second laser beam, a configuration design could also enable the energy of the first laser beam to be the same as the energy of the second laser beam; however, the angle of divergence of the first laser beam is different from the another angle of divergence of the second laser beam. Nevertheless, in the present disclosure, the energy of the first laser beam is different from the energy of the second laser beam, and/or the angle of divergence of the first laser beam is different from the another angle of divergence of the second laser beam.

Then, in step b), the switching unit is used to mask the second laser beam, thereby enabling transmitting the first laser beam toward a circuit board after passing through the switching unit, to transform a defective portion of a defective circuit into a sintered portion S2. After which, in step c), the switching unit is used to mask the first laser beam, thereby enabling transmitting the second laser beam toward the circuit board after passing through the switching unit, to carry out deflashing of the sintered portion, causing sintered sides of the sintered portion to be flush with two conducting sides of two conducting portions S3. The above-described steps will be explained in detail In the following description.

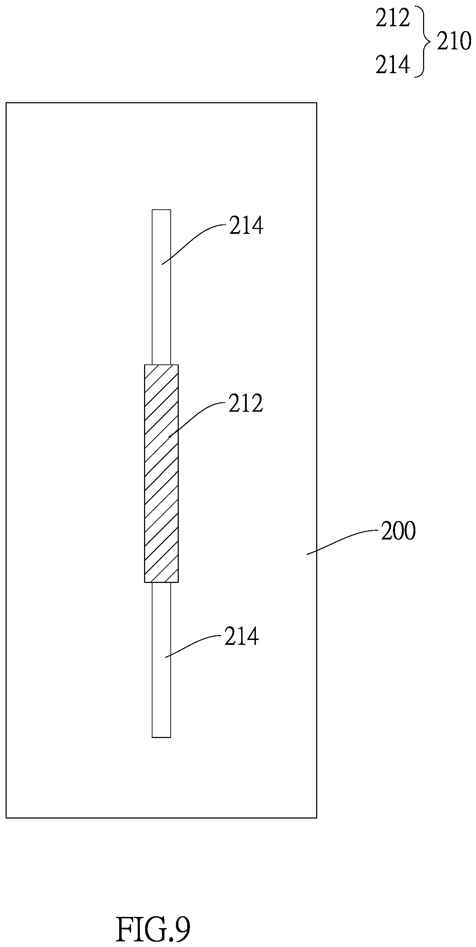

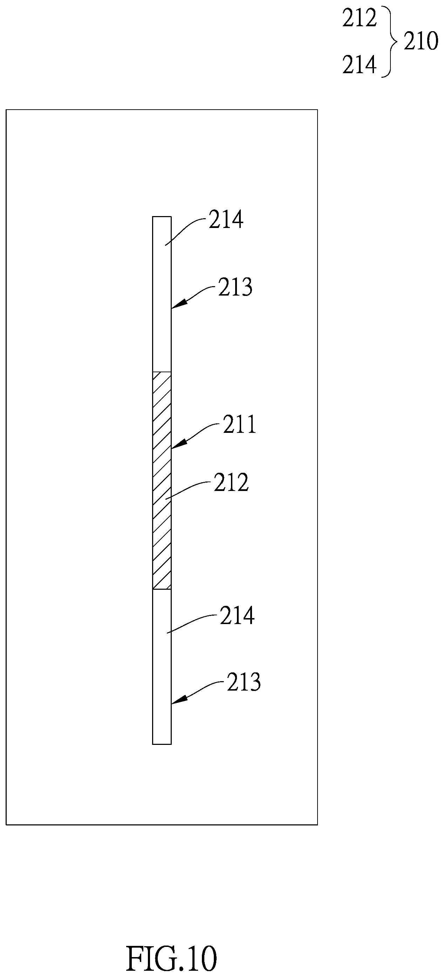

Referring to Figures 6 to 8 and Figures 9 and 10, wherein Figures 6 to 8 show cross-sectional views of the circuit 210 of the circuit board 200 with an open circuit defect in different states while undergoing repair according to an embodiment mode of the present disclosure; and Figures 9 and 10 show top views of the circuit 210 of the circuit board 200 with an open circuit defect in different states while undergoing repair according to an embodiment mode of the present disclosure. Referring to Figure 1, Figure 3, and Figures 6 to 10, wherein the operating method of the single laser repair device 100 is used to carry out repairs on the defective circuit 210 of the circuit board 200, wherein the defective circuit 210 has two conducting portions 214 and a defective portion 2121 located between the two conducting portions 214.

First, the operating method comprises driving and displacing the first displacement module 120, the second displacement module 130, and the third displacement module 140 along the first direction D1, the second direction D2, and the third direction D3, respectively, thereby displacing the single laser repair module 110 connected to the first displacement module 120 and the circuit board 200 on the loading platform 142 of the third displacement module 140. For example, the detector lens 116 of the single laser repair module 110 is used to detect the current position of the circuit board 200, producing a drive signal according to the current position that is used to drive movement of the first displacement module 120, the second displacement module 130, and the third displacement module 140, thereby enabling positioning the single laser repair module 110 and the circuit board 200 at a specific position. In addition, the loading platform 142 is displaced on the third displacement module 140, enabling the loading platform 142 to pass through the measuring modules 150 mounted on two sides of the third displacement module 140, whereby the measuring modules 150 are used to measure the thickness T of the circuit 210 in the circuit board 200.

In some of the embodiment modes, the laser light source 112 of the single laser dual optical circuit repair member 111 of the single laser repair module 110 emits the initial laser beam L0 toward the energy distribution unit 114, thereby producing a first laser beam L1 and a second laser beam L2 different from the first laser beam L1. Next. the first laser spot adjustment unit 1131 is used to receive the first laser beam L1 after passing through the energy distribution unit 114, and the second laser spot adjustment unit 1132 is used to receive the second laser beam L2 after passing through the energy distribution unit 114.

In some of the embodiment modes, a portion of the circuit 210 is removed, causing the circuit 210 to have the defective portion 2121; moreover, the two conducting portions 214 are two metal conducting wires or two polysilicon fuses, and the defect of the circuit 210 is an open circuit defect. In some of the embodiment modes, the inkjet head 118 of the single laser repair module 110 is used to spray a conductive resin C on the defective portion 2121 of the circuit 210, causing the conductive resin C to partially cover the two conducting portions 214. Next, the switching unit 115 is used to mask the second laser beam L2, thereby enabling transmitting the first laser beam L1 toward the circuit board 200 after passing through the switching unit 115, to transform the defective portion 2121 of the defective circuit 210 into a sintered portion 212. In other words, the first laser beam L1 is used to sinter the conductive resin C located on the circuit 210, thereby transforming the defective portion 2121 into the sintered portion 212. After which, the switching unit 115 is used to mask the first laser beam L1, thereby enabling transmitting the second laser beam L2 toward the circuit board 200 after passing through the switching unit 115, to carry out deflashing of the sintered portion 212, causing sintered sides 211 of the sintered portion 212 to be flush with two conducting sides 213 of the two conducting portions 214, as shown in Figure 10.

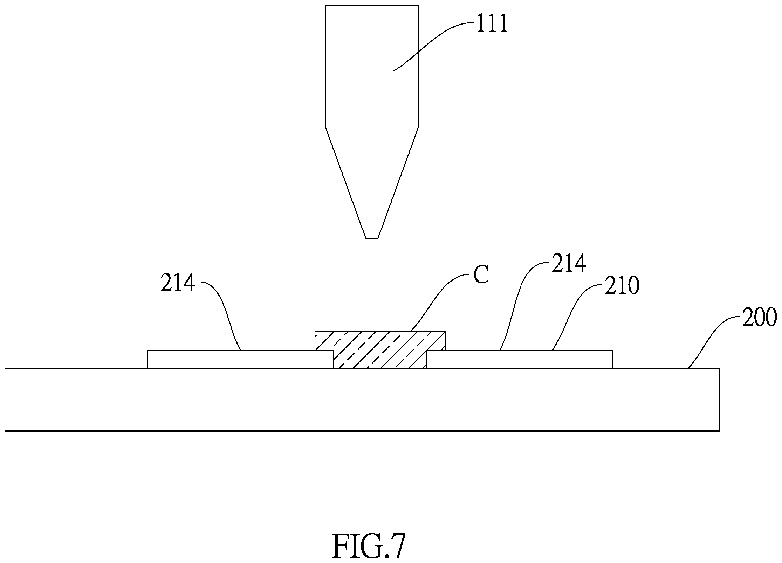

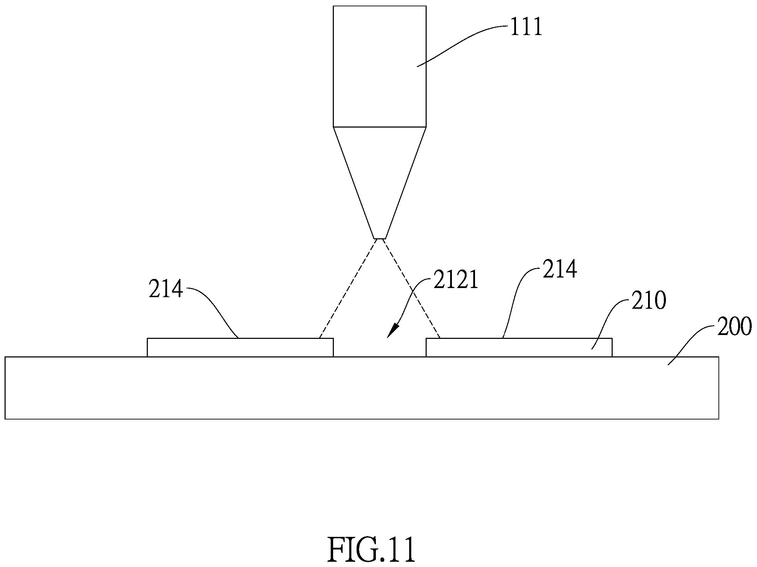

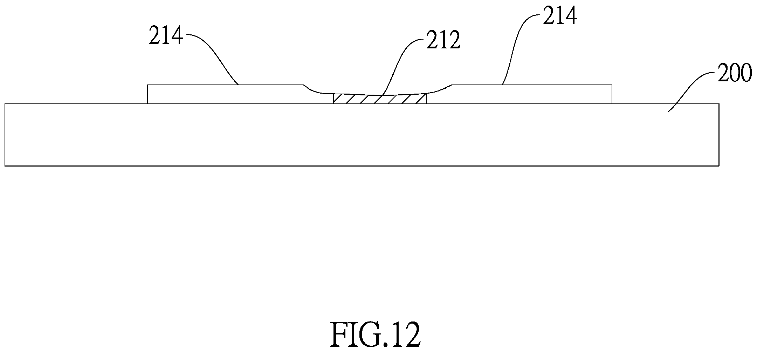

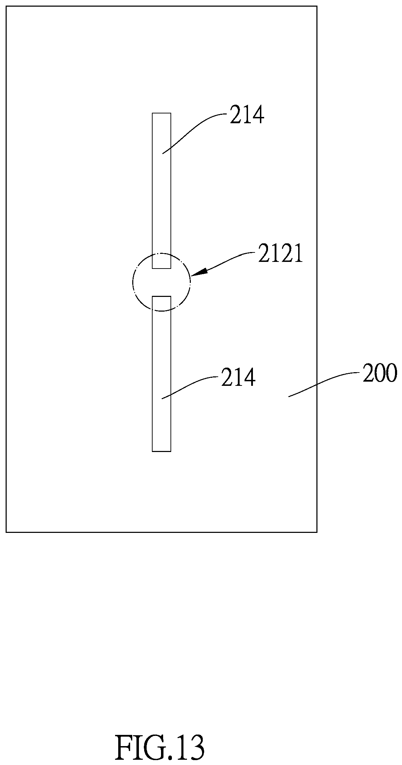

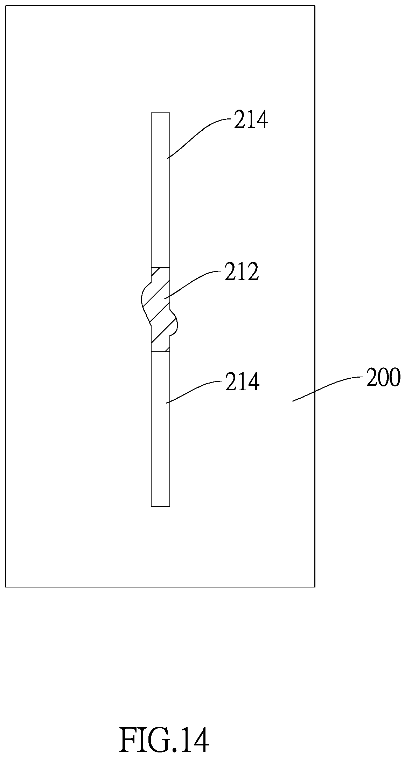

Referring to Figures 11 to 14, wherein Figures 11 and 12 show cross-sectional views of the circuit 210 of the circuit board 200 with an open circuit defect in different states while undergoing repair according to an embodiment mode of the present disclosure; and Figures 13 and 14 show top views of the circuit 210 of circuit board 200 with an open circuit defect in different states while undergoing repair according to an embodiment of the present disclosure. The differences between the embodiment modes shown in Figures 11 to 14 and the embodiment modes shown in Figures 6 to 10 lie in the single laser repair module 110 has not used the inkjet head 118 to spray the conductive resin C (as shown in Figure 7), but directly uses the first laser beam L1 to sinter the two corresponding sides of the two conducting portions 214 to diffusely cover the defective portion 2121, thereby transforming the defective portion 2121 into the sintered portion 212, and affording electrical conduction with the two conducting portions 214.

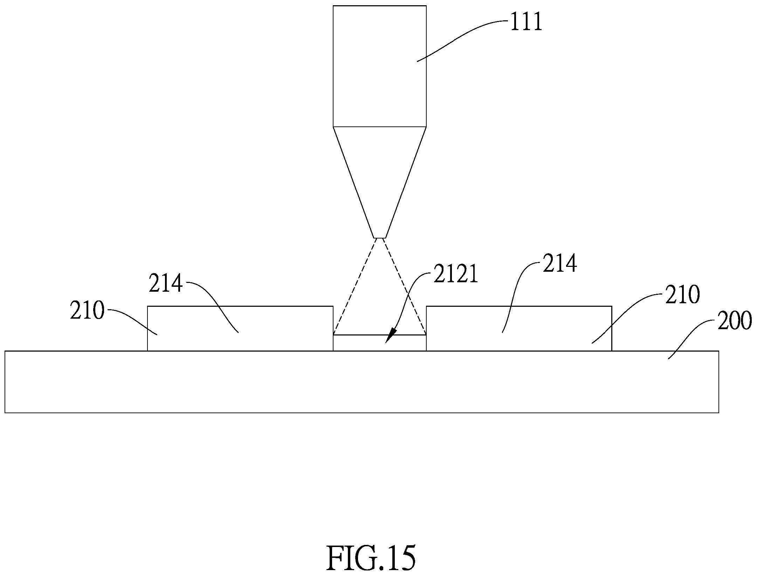

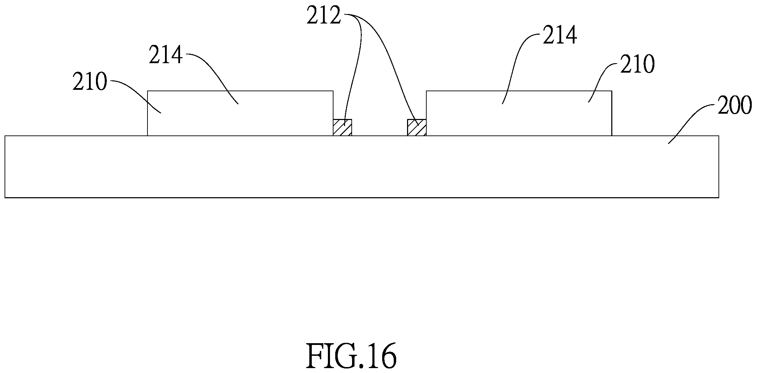

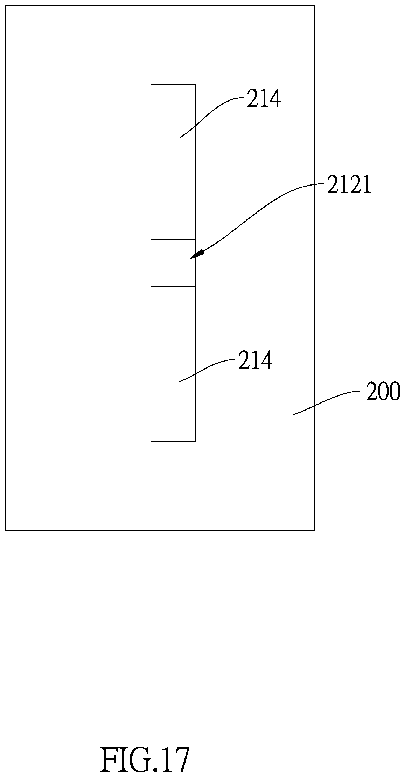

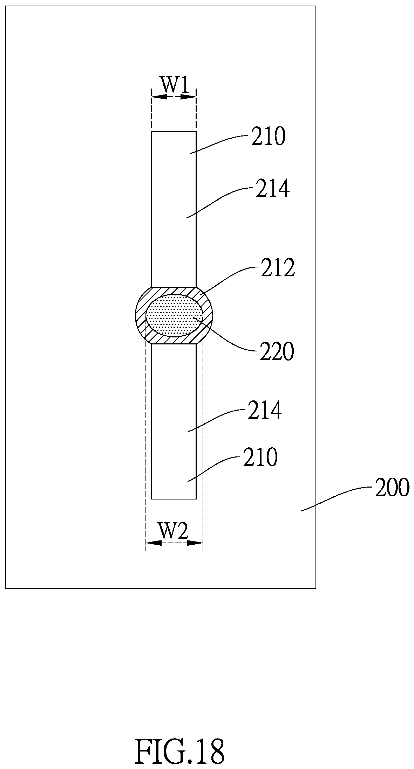

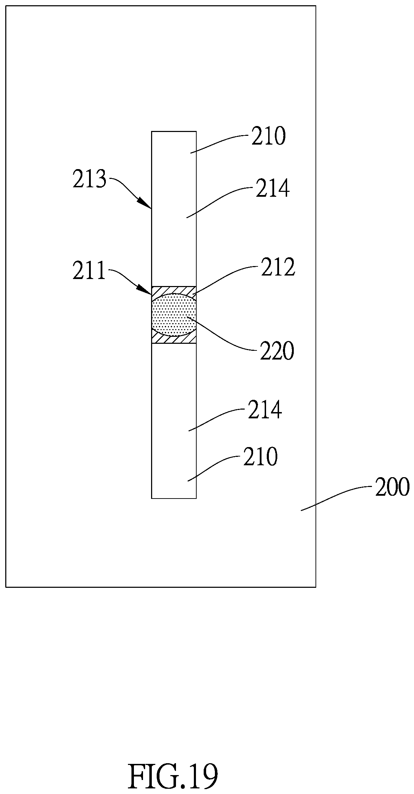

Referring to Figures 15 to 19, wherein Figures 15 and 16 show cross-sectional views of the circuit 210 of the circuit board 200 with a short circuit defect in different states while undergoing repair according to an embodiment mode of the present disclosure; and Figures 17 to 19 show top views of the circuit 210 of circuit board 200 with a short circuit defect in different states while undergoing repair according to the embodiment of the present disclosure. Referring to Figure 1, Figure 3, and Figures 15 to 19, two of the circuits 210 are provided in the embodiment mode of the present disclosure, and the defect between the two circuits 210 is a short circuit defect. First, the first laser beam L1 is used to sinter the defective portion 2121, causing a portion of the defective portion 2121 to diffuse outward and exposing.a portion of a substrate 220 of the circuit board 200, thereby transforming the defective portion 2121 into the sintered portion 212, as shown in Figure 18, wherein a width W1 of each of the two conducting portions 214, is smaller than a width W2 of the portion of the substrate 220 exposed by the sintered portion 212. After confirming the width W2 of the portion of the substrate 220 exposed by the sintered portion 212 is larger than the width W1 of the two conducting portions 214, then the second laser beam L2 is used to carry out deflashing of the sintered portion 212, causing the sintered sides 211 of the sintered portion 212 to be flush with the two conducting sides 213 of the two conducting portions 214, as shown in Figure 19.

In conclusion, the single laser repair device 100 is used to carry out repairs on the defective circuit 210 of the circuit board 200, wherein the single laser dual optical circuit repair member 111 can emit the first laser beam L1 and the second laser beam L2 with different energies and/or different angle of divergence toward the circuit board 200. In addition, the first laser beam L1 emitted by the single laser dual optical circuit repair member 111 transforms the defective portion 2121 of the circuit 210 into the sintered portion 212 between the two conducting portions 214; and the second laser beam L2 emitted by the single laser dual optical circuit repair member 111 carries out deflashing of the sintered portion 212, causing the sintered sides 211 of the sintered portion 212 to be flush with the conducting sides 213 of the conducting portions 214. The configuration of the first laser beam L1 and second laser beam L2 emitted by the single laser dual optical circuit repair member 111 of the single laser repair device 100 enables preventing the side surfaces of the repaired circuit contacting other circuits, thereby preventing short circuiting of the repaired circuit.

The above description outlines the characteristics of several embodiment modes, enabling technical personnel related to the field of the present invention to better understand the modality of the present disclosure. Persons skilled in the art will understand and can easily use the present disclosure as a basis for designing or modifying other processes and structures to achieve the same purpose as the embodiment modes described herein, and/or achieve the same advantages. Moreover, persons skilled in the art will also recognize that such equivalent structures do not deviate from the spirit and scope of the present disclosure, and that the embodiment modes described herein can be modified, replaced, and altered in various ways without departing from the scope of the present disclosure.

## Claims

1. A single laser repair device, which is used to carry out repairs on a defective circuit (210) of a circuit board (200), wherein the defective circuit (210) is provided with two conducting portions (214) and has a defective portion (2121) located therebetween; the single laser repair device comprising:
a single laser repair module (110), included with a single laser dual optical circuit repair member (111), which is configured in the single laser repair module (110), and included with a laser light source (112), which is used to emit an initial laser beam (L0); an energy distribution unit (114),
which is configured on one side of the laser light source (112), the initial laser beam (L0) passes through the energy distribution unit (114), thereby producing a first laser beam (L1) and a second laser beam (L2) different from the first laser beam (L1), wherein the energy of the first laser beam (L1) is different from the energy of the second laser beam (L2); and a switching unit (115), which is configured on one side of the energy distribution unit (114), and is used to mask the second laser beam (L2), thereby enabling transmitting the first laser beam (L1) passing through the switching unit (115) toward the circuit board (200), transforming the defective portion (2121) of the circuit (210) into a sintered portion (212), and after transforming the defective portion (2121) of the circuit (210) into the sintered portion (212), the switching unit (115) is used to mask the first laser beam (L1), and transmits the second laser beam (L2) passing through the switching unit (115) toward the circuit board (200), to carry out deflashing of the sintered portion (212), causing sintered sides (211) of the sintered portion (212) to be flush with two conducting sides (213) of the two conducting portions (214).

2. The single laser repair device according to claim 1, wherein the single laser dual optical circuit repair member (111) also comprising:
a first light spot adjustment unit (1131), which is positioned between the energy distribution unit (114) and the switching unit (115), and is used to receive the first laser beam (L1) after passing through the energy distribution unit (114); and
a second light spot adjustment unit (1132), which is positioned to one side of the first laser spot adjustment unit (1131), and is used to receive the second laser beam (L2) after passing through the energy distribution unit (114); wherein an angle of divergence of the first laser beam (L1) after passing through the first laser spot adjustment unit (1131) is different from another angle of divergence of the second laser beam (L2) after passing through the second laser spot adjustment unit (1132).

3. The single laser repair device according to claim 2, wherein the energy of the first laser beam (L1) after passing through the energy distribution unit (114) is greater than the energy of the second laser beam (L2) after passing through the energy distribution unit (114) and/or the angle of divergence of the first laser beam (L1) after passing through the first laser spot adjustment unit (1131) is greater than the another angle of divergence of the second laser beam (L2) after passing through the second laser spot adjustment unit (1132).

4. The single laser repair device according to claim 1, wherein the two conducting portions (214) are two metal conducting wires or two polysilicon fuses, a defect of the circuit (210) is a short circuit defect, and the first laser beam (L1) is used to sinter the defective portion (2121), causing a portion of the defective portion (2121) to diffuse outward and exposing a portion of a substrate (220) of the circuit board (200), thereby transforming the defective portion (2121) into the sintered portion (212), wherein a width (W1) of each of the two conducting portions (214) is smaller than a width (W2) of the portion of the substrate (220) exposed by the sintered portion (212).

5. The single laser repair device according to claim 1, wherein the two conducting portions (214) are two metal conducting wires or two polysilicon fuses, and the defect of the circuit (210) is an open circuit defect, and two corresponding sides of the two conducting portions (214) are sintered by the first laser beam (L1), to diffusely cover the defective portion (2121), thereby transforming the defective portion (2121) into the sintered portion (212), and affording electrical conduction with the two conducting portions (214).

6. The single laser repair device according to claim 1, wherein the two conducting portions (214) are two metal conducting wires or two polysilicon fuses, and the defect of the circuit (210) is an open circuit defect, the single laser repair module (110) is provided with an inkjet head (118), which is used to spray a conductive resin (C) on the defective portion (2121) of the circuit (210), causing the conductive resin (C) to partially cover the two conducting portions (214), and the first laser beam (L1) is used to sinter the conductive resin (C) located on the circuit (210), thereby transforming the defective portion (2121) into the sintered portion (212).

7. The single laser repair device according to claim 1, further comprising
a first displacement module (120), which is connected to the single laser repair module (110), and is used to displace the single laser repair module (110) in a first direction (D1);
a second displacement module (130), which is connected to the first displacement module (120), and is used to displace the first displacement module (120) in a second direction (D2);
a third displacement module (140), which is provided with a loading platform (142), wherein the loading platform (142) is used to load-support the circuit board (200), and the third displacement module (140) is used to displace the loading platform (142) in a third direction (D3), each of the first direction (D1), the second direction (D2), and the third direction (D3) is perpendicular to the other two directions; and
measuring modules (150), which are correspondingly mounted on two sides of the third displacement module (140), wherein when the third displacement module (140) drives movement of the loading platform (142) through the measuring modules (150), the measuring modules (150) are used to measure a thickness (T) of the circuit (210) in the circuit board (200).

8. The single laser repair device according to claim 7, wherein the single laser repair module (110) is provided with a detector lens (116), the detector lens (116) is orientated toward the circuit board (200), and is used to detect the current position of the circuit board (200) and produce a drive signal according to the current position, wherein the drive signal is used to drive movement of the first displacement module (120), the second displacement module (130), and the third displacement module (140), thereby enabling positioning the single laser repair module (110) and the circuit board (200) at a specific position.

9. An operating method for a single laser repair device, which is used to carry out repairs on a defective circuit (210) of a circuit board (200), wherein the defective circuit (210) is provided with two conducting portions (214) and has a defective portion (2121) located therebetween; the operating method comprising steps of:
a) using a single laser dual optical circuit repair member (111) of a single laser repair module (110) to emit an initial laser beam (L0) toward an energy distribution unit (114), thereby producing a first laser beam (L1) and a second laser beam (L2) different from the first laser beam (L1), wherein the energy of the first laser beam (L1) is different from the energy of the second laser beam (L2);
b) using a switching unit (115) to mask the second laser beam (L2), and enabling transmitting the first laser beam (L1) toward the circuit board (200) after passing through the switching unit (115), thereby transforming the defective portion (2121) of the defective circuit (210) into a sintered portion (212); and
c) using the switching unit (115) to mask the first laser beam (L1), and enabling transmitting the second laser beam (L2) passing through the switching unit (115) toward the circuit board (200), to carry out deflashing of the sintered portion (212), causing sintered sides (211) of the sintered portion (212) to be flush with two conducting sides (213) of the two conducting portions (214).

10. The operating method according to claim 9, further comprising
using a first laser spot adjustment unit (1131) to receive the first laser beam (L1) after passing through the energy distribution unit (114), and using a second laser spot adjustment unit (1132) to receive the second laser beam (L2) after passing through the energy distribution unit (114), wherein an angle of divergence of the first laser beam (L1) after passing through the first laser spot adjustment unit (1131) is different from another angle of divergence of the second laser beam (L2) after passing through the second laser spot adjustment unit (1132).

11. The operating method according to claim 9, wherein transforming the defective portion (2121) into the sintered portion (212) further comprising:
using the first laser beam (L1) to sinter two corresponding sides of the two conducting portions (214) to diffusely cover the defective portion (2121), thereby transforming the defective portion (2121) into the sintered portion (212) and affording electrical conduction with the two conducting portions (214).

12. The operating method according to claim 9, wherein transforming the defective portion (2121) into the sintered portion (212) further comprising:
removing a portion of the circuit (210), causing the circuit (210) to have the defective portion (2121), wherein the defect of the circuit (210) is an open circuit defect, and the two conducting portions (214) are two metal conducting wires or two polysilicon fuses;
using an inkjet head (118) of the single laser repair module (110) to spray a conductive resin (C) on the defective portion (2121) of the circuit (210), wherein the conductive resin (C) partially covers the two conducting portions (214); and
using the first laser beam (L1) to sinter the conductive resin (C) located on the circuit (210), thereby transforming the defective portion (2121) into the sintered portion (212).

13. The operating method according to claim 9, wherein transforming the defective portion (2121) into the sintered portion (212) further comprising:
using the first laser beam (L1) to sinter the defective portion (2121), causing a portion of the defective portion (2121) to diffuse outward and exposing a portion of a substrate (220) of the circuit board (200), thereby transforming the defective portion (2121) into the sintered portion (212),
wherein the defect of the circuit (210) is a short circuit defect, and a width (W1) of each of the two conducting portions (214) is smaller than a width (W2) of the portion of the substrate (220) exposed by the sintered portion (212).

14. The operating method according to claim 9, further comprising:
driving and displacing a first displacement module (120), a second displacement module (130), and a third displacement module (140) along a first direction (D1), a second direction (D2), and a third direction (D3), respectively, thereby enabling displacing the single laser repair module (110) connected to the first displacement module (120) and the circuit board (200) on the loading platform (142) of the third displacement module (140), wherein each of the first direction (D1), the second direction (D2), and the third direction (D3) is perpendicular to the other two directions; and
using a detector lens (116) of the single laser repair module (110) to detect the current position of the circuit board (200) and produce a drive signal according to the current position, wherein the drive signal is used to drive movement of the first displacement module (120), the second displacement module (130), and the third displacement module (140), thereby enabling positioning the single laser repair module (110) and the circuit board (200) at a specific position.

15. The operating method according to claim 14, further comprising:
displacing the loading platform (142) on the third displacement module (140), enabling the loading platform (142) to pass through measuring modules (150) mounted on two sides of the third displacement module (140); and
using the measuring modules (150) to measure a thickness (T) of the circuit (210) in the circuit board (200).
